(19) Europäisches Patentamt
European Patent Office
Office européen des brevets

(11) **EP 3 667 932 B1**

(12) **FASCICULE DE BREVET EUROPEEN**

(45) Date de publication et mention
de la délivrance du brevet:
**09.11.2022 Bulletin 2022/45**

(21) Numéro de dépôt: **19212028.5**

(22) Date de dépôt: **28.11.2019**

(51) Classification Internationale des Brevets (IPC):
**H04B 3/54** (2006.01)    **G01D 4/00** (2006.01)

(52) Classification Coopérative des Brevets (CPC):
**H04B 3/544; H04B 3/542;** H04B 2203/5408;
H04B 2203/5433; H04B 2203/5491

(54) **DISPOSITIF DE RECEPTION DE SIGNAUX CPL**

CPL-SIGNAL-EMPFANGSVORRICHTUNG

DEVICE FOR RECEIVING PLC SIGNALS

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **10.12.2018 FR 1872632**

(43) Date de publication de la demande:
**17.06.2020 Bulletin 2020/25**

(73) Titulaire: **Sagemcom Energy & Telecom SAS
92500 Rueil-Malmaison (FR)**

(72) Inventeurs:
• **TEBOULLE, Henri
92500 Rueil Malmaison (FR)**
• **GRINCOURT, Christophe
92500 Rueil Malmaison (FR)**

(74) Mandataire: **Lavaud, Thomas et al
Cabinet Boettcher
16, rue Médéric
75017 Paris (FR)**

(56) Documents cités:
**EP-A1- 3 104 569     WO-A1-2016/166238**

## Description

L'invention concerne le domaine des dispositifs de réception de signaux CPL.

ARRIERE PLAN DE L'INVENTION

Certains compteurs électriques modernes sont conçus pour communiquer par courants porteurs en ligne (« CPL ») et donc pour émettre et recevoir des signaux CPL. Le protocole CPL-G3 a en particulier été développé récemment pour permettre une gestion optimisée des réseaux électriques dits « intelligents ».

La communication CPL selon ce protocole utilise principalement trois bandes de fréquences : la bande CENELEC-A (fréquences comprises entre 35kHz et 91kHz), la bande FCC (fréquences comprises entre 154kHz et 488kHz) et la bande ARIB (fréquences comprises entre 154kHz et 484kHz). D'autres bandes de fréquences peuvent être envisagées, comme la bande CENELEC-B (fréquences comprises entre 98kHz et 122kHz). Des industriels chinois travaillent actuellement sur une future bande G3 M (fréquences comprises entre 100kHz et 2 à 3MHz).

Chacune de ces bandes de fréquences est définie par un organisme de normalisation d'un pays ou d'un continent particulier, et est donc destinée en premier lieu à être utilisée dans ce pays ou dans ce continent. Ainsi, les bandes CENELEC-A et CENELEC-B sont principalement utilisées en Europe, la bande FCC aux Etats-Unis et la bande ARIB au Japon. Cependant, il existe des réseaux électriques sur lesquels cohabitent plusieurs bandes de fréquences.

On comprend qu'il serait très intéressant d'un point de vue économique de disposer d'un compteur électrique pouvant être utilisé à la fois dans un réseau électrique sur lequel une première bande de fréquences est utilisée, par exemple la bande CENELEC-A, et dans un réseau électrique sur lequel une deuxième bande de fréquences est utilisée, par exemple la bande FCC. Un tel compteur électrique pourrait ainsi être commercialisé dans plusieurs pays sans modifier son interface de communication CPL.

On comprend aussi que, dans le cas où plusieurs bandes de fréquences, par exemple la bande de fréquences CENELEC-A et la bande de fréquences FCC, cohabitent sur un même réseau électrique, il est essentiel que le compteur électrique soit capable de communiquer en utilisant toutes ces bandes de fréquences ou, tout au moins, en utilisant une seule bande de fréquences mais sans être perturbé par la présence des autres bandes de fréquences.

Cependant, la mise en œuvre d'un tel compteur électrique n'est pas chose aisée. On sait notamment que la présence, dans un réseau électrique, de signaux CPL dans la bande FCC, a un impact négatif important sur la qualité de réception d'un compteur électrique prévu pour communiquer dans la bande CENELEC A.

Des exemples d'art antérieure sont divulgués dans la demande internationale de brevet WO2016/166238 A1 et dans la demande de brevet européen EP 3104569 A1.

OBJET DE L'INVENTION

L'invention a pour objet d'améliorer la réception de signaux CPL dans un réseau électrique alors que plusieurs bandes de fréquences distinctes sont susceptibles d'être utilisées, voire même de cohabiter, sur le réseau électrique.

RESUME DE L'INVENTION

En vue de la réalisation de ce but, on propose un dispositif de réception de signaux CPL, comprenant:

- un étage de filtrage relié à une entrée du dispositif de réception et configurable selon au moins deux modes comprenant un mode par défaut, dans lequel l'étage de filtrage laisse passer au moins des premiers signaux CPL inclus dans une première bande de fréquences et des deuxièmes signaux CPL inclus dans une deuxième bande de fréquences distincte de la première bande de fréquences, et un premier mode de sélection, dans lequel l'étage de filtrage laisse passer les premiers signaux CPL et empêche le passage des deuxièmes signaux CPL ;
- un circuit de traitement relié à l'étage de filtrage et agencé pour recevoir des trames de signaux CPL, et, pour chaque trame reçue, pour analyser un préambule de la trame de manière à déterminer si la trame est une trame de premiers signaux CPL ou de deuxièmes signaux CPL, et pour configurer dynamiquement l'étage de filtrage dans le premier mode de sélection si la trame est une trame de premiers signaux CPL de manière à optimiser la réception et le décodage de ladite trame.

Pour chaque trame reçue, le dispositif de réception selon l'invention analyse le préambule de la trame, détermine si celle-ci est une trame de premiers signaux CPL ou de deuxièmes signaux CPL, et adapte dynamiquement le filtrage. Ainsi, pour chaque trame reçue dans une bande de fréquences particulière, le dispositif de réception optimise à la fois la réception de la trame et le rejet des autres bandes de fréquences. Le dispositif de réception permet donc de recevoir indifféremment des trames de premiers signaux CPL et de deuxièmes signaux CPL, avec un excellent rapport signal sur bruit, même lorsque celles-ci cohabitent sur un même réseau électrique.

On propose de plus un équipement électrique comportant le dispositif de réception qui vient d'être décrit.

On propose de plus un procédé de réception de signaux CPL, utilisant le dispositif de réception qui vient d'être décrit, comprenant les étapes, pour chaque trame reçue, de :

- avant la réception de la trame, configurer l'étage de filtrage dans le mode par défaut ;
- acquérir et analyser le préambule de la trame, de manière à déterminer si la trame est une trame de premiers signaux CPL ou de deuxièmes signaux CPL ;
- configurer dynamiquement l'étage de filtrage dans le premier mode de sélection si la trame est une trame de premiers signaux CPL.

On propose de plus un programme d'ordinateur comprenant des instructions pour mettre en œuvre, par un composant de traitement d'un modem, le procédé de réception qui vient d'être décrit.

On propose en outre des moyens de stockage, caractérisés en ce qu'ils stockent un programme d'ordinateur comprenant des instructions pour mettre en œuvre, par un composant de traitement d'un modem, le procédé de réception qui vient d'être décrit.

L'invention sera mieux comprise à la lumière de la description qui suit d'un mode de mise en œuvre particulier non limitatif de l'invention.

BREVE DESCRIPTION DES DESSINS

Il sera fait référence aux dessins annexés, parmi lesquels :

[Fig. 1] la figure 1 représente un schéma d'un dispositif de réception selon l'invention ;
[Fig. 2a] la figure 2a représente un graphique sur lequel est représentée une courbe d'un gain d'un filtre de base ; [Fig. 2b] la figure 2b représente un graphique sur lequel est représentée une courbe d'un gain d'un premier circuit de filtrage additionnel ;
[Fig. 2c] la figure 2c représente un graphique sur lequel est représentée une courbe d'un gain d'un deuxième circuit de filtrage additionnel ;
[Fig. 3] la figure 3 représente des symboles d'un préambule d'une trame d'un signal CPL ;
[Fig. 4] la figure 4 représente des signaux électriques correspondant à un symbole SYNCP de la figure 3, pour une trame d'un premier signal CPL (bande CENELEC-A) ;
[Fig. 5] la figure 5 représente des signaux électriques correspondant à un symbole SYNCP de la figure 3, pour une trame d'un deuxième signal CPL (bande FCC).

DESCRIPTION DETAILLEE DE L'INVENTION

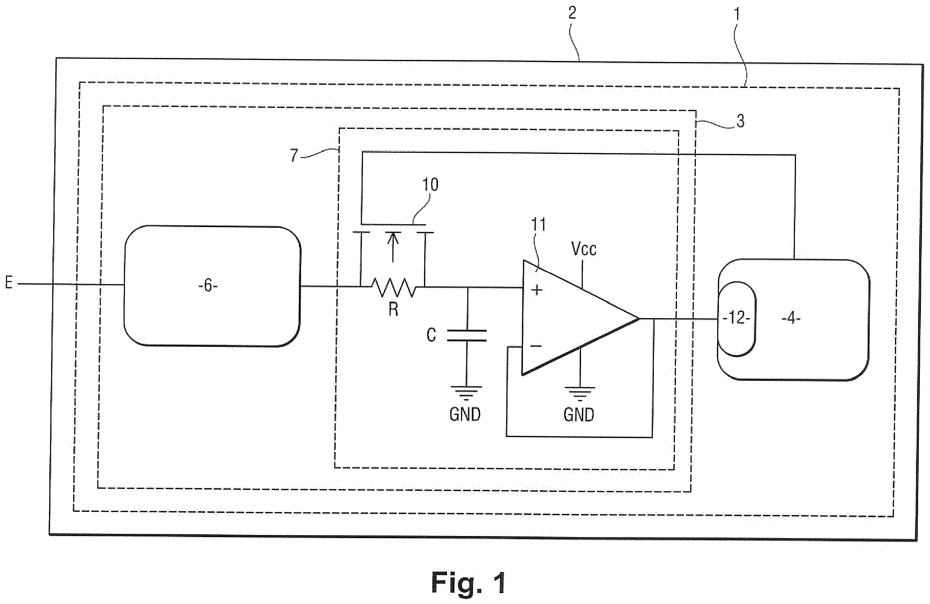

En référence à la figure 1, le dispositif de réception selon l'invention 1 est ici mis en œuvre dans un compteur électrique 2. Le compteur électrique 2 est utilisé pour mesurer la consommation en énergie électrique d'une installation qui est reliée à un réseau électrique.

Le dispositif de réception 1 permet au compteur électrique 2 de recevoir des signaux CPL circulant sur le réseau électrique. Deux bandes de fréquences distinctes cohabitent sur le réseau électrique : une première bande de fréquences, en l'occurrence la bande CENELEC-A, et une deuxième bande de fréquences, en l'occurrence la bande FCC. Ces deux bandes de fréquences sont aussi « disjointes », c'est-à-dire qu'elles ne se chevauchent pas et ne comprennent donc aucune fréquence en commun.

Le dispositif de réception 1 comporte une entrée E reliée au réseau électrique, un étage de filtrage 3, et un circuit de traitement 4.

L'étage de filtrage 3 est relié à l'entrée E du dispositif de réception 1, de sorte que les signaux CPL reçus par le dispositif de réception 1 passent directement dans l'étage de filtrage 3.

L'étage de filtrage 3 comporte un filtre de base 6 et un circuit de filtrage additionnel 7 qui est ici positionné en sortie du filtre de base 6.

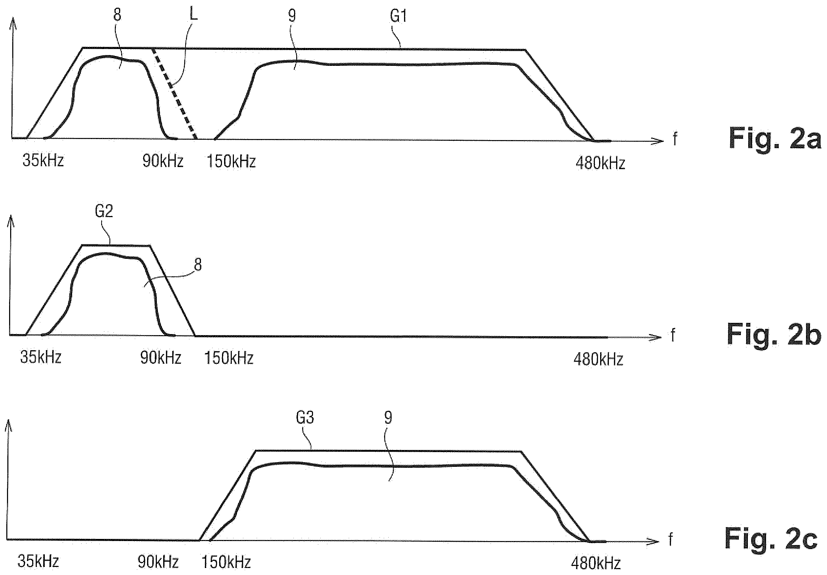

Le gain G1 du filtre de base 6 est visible sur la figure 2a. On voit que le filtre de base 6 laisse passer à la fois des premiers signaux CPL inclus dans la première bande de fréquences (CENELEC-A) 8 et des deuxièmes signaux CPL inclus dans la deuxième bande de fréquences (FCC) 9. Le filtre de base 6 agit comme un filtre passe-haut pour la première bande de fréquences 8, c'est-à-dire qu'il coupe les fréquences inférieures à la première bande de fréquences 8 et qu'il laisse passer les fréquences supérieures à la première bande de fréquences 8, et comme un filtre passe-bas pour la deuxième bande de fréquences 9, c'est-à-dire qu'il coupe les fréquences supérieures à la deuxième bande de fréquences 9 et qu'il laisse passer les fréquences inférieures à la deuxième bande de fréquences 9.

Le circuit de filtrage additionnel 7 comprend une résistance R, un condensateur C, un composant de commutation 10 et un amplificateur opérationnel 11.

La résistance R a ici une valeur de résistance de 1,3kΩ (précision de 1%). Le condensateur C a une valeur de capacité de 1nF (précision de 5%). La résistance R a une première borne reliée à la sortie du filtre de base 6 et une deuxième borne reliée à une première borne du condensateur C. Le condensateur C a une deuxième borne reliée à la masse GND. La résistance R et le condensateur C forment un filtre RC passe-bas de fréquence de coupure fc telle que :

$$fc = 1/2\pi RC = 122,43kHz.$$

Le composant de commutation 10 est ici un transistor MOSFET Type N qui est monté entre les bornes de la résistance R. Le drain du transistor 10 est connecté à la première borne de la résistance R et la source du transistor 10 est connecté à la deuxième borne de la résistance R.

La deuxième borne de la résistance R et la première borne du condensateur C sont reliées à une entrée non-inverseuse de l'amplificateur opérationnel 11. L'entrée inverseuse de l'amplificateur opérationnel 11 est reliée à la sortie de l'amplificateur opérationnel 11. L'amplificateur opérationnel 11 est ainsi monté en suiveur.

Le circuit de traitement 4 est ici un modem CPL G3. Le circuit de traitement 4 comporte un composant de traitement (non représenté). Le composant de traitement est ici un microcontrôleur mais pourrait être un composant différent, par exemple un processeur, un FPGA, un ASIC, etc. Le composant de traitement est adapté à exécuter des instructions d'un programme pour mettre en œuvre la réception des signaux CPL.

Le circuit de traitement 4 comporte un convertisseur analogique-numérique 12 relié à la sortie de l'amplificateur opérationnel 11. Le convertisseur analogique-numérique 12 numérise donc les signaux CPL qui ont cheminé via l'étage de filtrage 3.

Le circuit de traitement 4 est relié à la grille du transistor 10. Le circuit de traitement 4 peut donc piloter le transistor 10 de sorte que celui-ci soit sélectivement dans un état ouvert ou dans un état fermé.

On décrit maintenant plus en détail le fonctionnement du dispositif de réception selon l'invention 1.

L'étage de filtrage 3, grâce au transistor 10, est configurable selon au moins deux modes : un mode par défaut et un premier mode de sélection.

Le mode par défaut est un mode dans lequel le transistor 10 se trouve dans un premier état, qui est un état fermé. Dans ce cas, la résistance R est court-circuitée et le circuit de filtrage additionnel 7 remplit uniquement une fonction de suiveur en sortie du filtre de base 6. Le circuit de filtrage additionnel 7 ne modifie pas le filtrage réalisé par le filtre de base 6.

Le circuit de traitement 4 configure l'étage de filtrage 3 dans le mode par défaut avant la réception de chaque nouvelle trame, c'est-à-dire qu'il commande le transistor 10 pour que celui-ci se trouve dans un état fermé.

Lorsqu'une trame de signaux CPL est reçue, les signaux CPL traversent l'étage de filtrage 3 (via le filtre de base 6 et le circuit de filtrage additionnel 7 formant suiveur), et sont acquis et numérisés par le convertisseur analogique-numérique 12 du circuit de traitement 4.

Le circuit de traitement 4 analyse le préambule de la trame pour déterminer si la trame est une trame de premiers signaux CPL ou de deuxièmes signaux CPL.

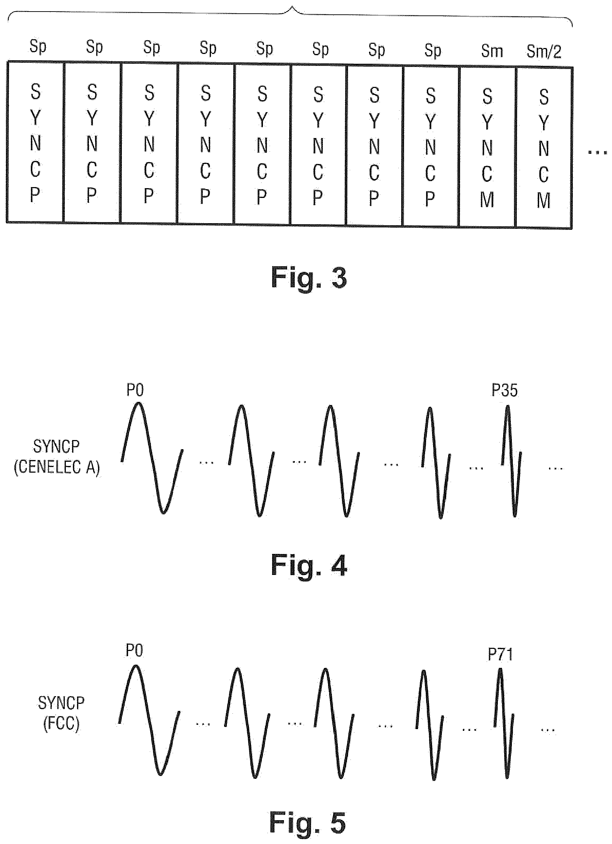

En référence à la figure 3, le préambule d'une trame de signaux CPL dans le protocole CPL-G3 comprend un symbole SYNCP (Sp), répété huit fois, puis un symbole SYNCM (Sm ; répété 1,5 fois) qui est en opposition de phase par rapport au symbole SYNCP. Ceci est valable à la fois pour les premiers signaux CPL (CENELEC-A) et pour les deuxièmes signaux CPL (FCC).

En référence à la figure 4, dans le cas des premiers signaux CPL, chaque symbole est transmis via 36 porteuses P0...P35 consécutives allant de 35kHz à 91kHz. Dans le cas des deuxièmes signaux CPL, en référence à la figure 5, chaque symbole est transmis via 72 porteuses consécutives P0...P71 allant de 154kHz à 488kHz.

Le circuit de traitement 4 analyse donc le préambule de la trame reçue ou, plus exactement, des échantillons du préambule de la trame, lesdits échantillons étant produits par le convertisseur analogique-numérique 12.

Cette analyse peut comprendre l'étape d'appliquer une transformée de Fourier inverse sur les échantillons du préambule de la trame. La transformée de Fourier inverse permet de déterminer quelles fréquences constituent les symboles, et donc si la trame est une trame de premiers signaux CPL ou de deuxièmes signaux CPL.

Cette analyse peut alternativement comprendre l'étape de calculer une intercorrélation entre les échantillons du préambule et un signal de référence.

Le signal de référence est par exemple un préambule d'une trame CENELEC-A de référence.

L'analyse est réalisée sur un nombre prédéterminé de symboles du préambule de la trame reçue, par exemple sur cinq symboles.

Le nombre prédéterminé peut être différent de cinq. Il est préférable de ne pas réaliser l'analyse sur un nombre trop important de symboles, pour que cette analyse s'achève bien avant la fin du préambule. Un nombre prédéterminé égal à cinq correspond à un bon compromis pour que l'analyse soit suffisamment précise sans être trop longue.

On note $X1_m$ les N échantillons correspondant au signal de référence, et $X2_n$ les N échantillons du préambule de la trame reçue. On calcule alors la somme S qui est telle que :

$$S = \sum_{n=0}^{N-1} \sum_{m=0}^{N-1} X2_n . X1_m$$

Lorsque le préambule et le signal de référence sont de même nature (c'est-à-dire ici tous les deux des signaux CPL en CENELEC-A), le bruit est moyenné et s'annule. La valeur de la somme S est donc significative d'une présence de corrélation entre le préambule de la trame reçue et le signal de référence. La somme S atteint une valeur pic.

Ainsi, lorsque la somme S est positive strictement et est supérieure à un seuil prédéfini Scor, on considère que le préambule et le signal de référence sont de même nature.

Par contre, lorsque la somme S est presque nulle et est inférieure strictement au seuil prédéfini Scor, on en déduit que le préambule de la trame reçue et le signal de référence sont de même nature.

Bien sûr, on peut aussi utiliser comme signal de référence un préambule d'une trame FCC de référence, voire même calculer la somme S du préambule de chaque trame reçue avec les deux signaux de référence (CENELEC-A et FCC).

Si le circuit de traitement 4 détecte que le préambule de la trame reçue correspond au préambule des premiers signaux CPL, le circuit de traitement 4 configure l'étage de filtrage 3 selon le premier mode de sélection. Le circuit de traitement 4 commande le transistor 10 pour que celui-ci passe dans un deuxième état, qui est un état ouvert.

Lorsque le transistor 10 est dans l'état ouvert, le circuit de filtrage additionnel 7 remplit une fonction de filtre qui s'ajoute au filtre de base 6. La résistance R n'est plus court-circuitée et le filtre RC passe-bas est actif et agit sur le filtre de base 6. Le gain de l'étage de filtrage 3 est alors défini dans les fréquences supérieures par la ligne en pointillés L sur la figure 2a et devient le gain G2 visible sur la figure 2b. L'étage de filtrage 3 coupe les fréquences juste au-dessus et juste au-dessous de la première bande de fréquences 8 des premiers signaux CPL (CENELEC-A), et rejette ainsi les deuxièmes signaux CPL (FCC).

Ainsi, la présence possible de deuxièmes signaux CPL sur le réseau électrique ne perturbe pas la réception du reste de la trame reçue. On optimise dynamiquement la réception et le décodage de la trame, pendant la réception de la trame, à partir de l'analyse du préambule de ladite trame. On réduit le rapport signal sur bruit en réception des premiers signaux CPL.

Par contre, si le circuit de traitement 4 détecte que le préambule de la trame reçue ne correspond pas au préambule des premiers signaux CPL, mais au préambule des deuxièmes signaux CPL, le circuit de traitement 4 laisse l'étage de filtrage 3 dans le mode par défaut. Le gain de l'étage de filtrage 3 correspond donc au gain G1. L'étage de filtrage 3 laisse passer à la fois les premiers signaux CPL et les deuxièmes signaux CPL. La réception et le décodage de la suite de la trame ne sont cependant pas perturbés. En effet, on a constaté que la réception de trames appartenant aux deuxièmes signaux CPL (FCC) n'est pas perturbée par la présence de trames des premiers signaux CPL (CENELEC-A).

Enfin, suite à la réception complète de la trame, quelle que soit la nature de la trame qui vient d'être reçue (CENELEC-A ou FCC), le circuit de traitement 4 reconfigure l'étage de filtrage 3 selon le mode par défaut en commandant le transistor 10 dans l'état fermé.

Chaque trame est ensuite traitée par le compteur électrique 2 suite à sa réception, c'est-à-dire acquise et analysée si le compteur électrique 2 est bien le destinataire de la trame, ou bien rejetée ou retransmise sur le réseau électrique si le compteur électrique 2 n'est pas le destinataire de la trame.

On note ici que la reconfiguration de l'étage de filtrage 3 par le circuit de traitement 4 n'utilise qu'un seul composant de commutation (transistor MOSFET 10). Cette caractéristique est particulièrement avantageuse. En effet, avec deux transistors MOSFET, les commutations ne se dérouleraient pas exactement en même temps, car on ne maîtrise pas précisément le temps de commutation d'un MOSFET. L'utilisation de deux transistors MOSFET produirait des signaux transitoires parasites qui perturberaient la réception de la trame. Dans le dispositif de réception selon l'invention 1, un seul transistor MOSFET 10 est utilisé et on évite de la sorte la présence de ces signaux transitoires parasites.

Avantageusement, on pourrait prévoir la possibilité de configurer l'étage de filtrage 3 selon un deuxième mode de sélection, dans lequel l'étage de filtrage 3 laisse passer les deuxièmes signaux CPL et empêche le passage des premiers signaux CPL.

On ajoute pour cela un deuxième circuit de filtrage additionnel, qui comprend par exemple un transistor MOSFET, un filtre RC passe-haut ayant une fréquence de coupure proche mais inférieure à 150kHz, et un amplificateur monté en suiveur. Le transistor MOSFET est par exemple monté entre les bornes du condensateur.

Ainsi, au cours de l'analyse du préambule de chaque trame reçue, si le circuit de traitement 4 détermine que la trame en cours de réception est une trame des deuxièmes signaux CPL, le circuit de traitement 4 configure l'étage de filtrage 3 selon le deuxième mode de sélection. Le gain de l'étage de filtrage 3 devient le gain G3, visible sur la figure 2c. L'étage de filtrage 3 coupe les fréquences juste au-dessus et juste au-dessous de la deuxième bande de fréquences 9 des deuxièmes signaux CPL (FCC).

On remarque que, dans ce cas, même si l'étage de filtrage 3 comprend deux transistors MOSFET (un pour le premier circuit de filtrage additionnel destiné à optimiser la réception des premiers signaux CPL et un pour le deuxième circuit de filtrage additionnel destiné à optimiser la réception des deuxièmes signaux CPL), on ne génère pas pour autant les signaux transitoires parasites qui viennent d'être évoqués. En effet, le circuit de traitement 4 reconfigure l'étage de filtrage 3 dans le mode par défaut avant la réception de chaque nouvelle trame, ce qui revient à avoir les deux transistors MOSFET dans l'état fermé. Si le circuit de traitement 4 détermine que la trame est une trame de premiers signaux CPL, seul le transistor MOSFET du premier circuit de filtrage additionnel est activé pour passer dans l'état ouvert. De même, si le circuit de traitement 4 détermine que la trame est une trame de deuxièmes signaux CPL, seul le transistor MOSFET du deuxième circuit de filtrage additionnel est activé pour passer dans l'état ouvert.

Bien entendu, l'invention n'est pas limitée au mode de réalisation décrit mais englobe toute variante entrant dans le champ de l'invention telle que définie par les revendications.

Il est bien évident que les premiers signaux CPL peuvent être des signaux autres que des signaux CENELEC-A et que les deuxièmes signaux CPL peuvent être des signaux autres que des signaux FCC. On pourrait par exemple remplacer les signaux de la bande FCC par des signaux de la bande ARIB.

On pourrait aussi avoir plus de deux bandes de fréquences différentes cohabitant sur le réseau électrique, et par exemple la bande CENELEC-A, la bande CENELEC-B et la bande FCC. L'étage de filtrage est dans ce cas configuré pour optimiser au mieux la réception de ces trois bandes.

On a décrit ici d'utiliser un filtre de base associé soit à un unique circuit de filtrage additionnel (un filtre RC passe-bas), soit à un premier circuit de filtrage additionnel (un filtre RC passe-bas) et à un deuxième circuit de filtrage additionnel (un filtre RC passe-haut).

On peut bien sûr envisager d'utiliser des filtres différents, configurés différemment. On pourrait par exemple avoir un unique filtre passe-bas présentant deux fréquences de coupure obtenues chacune grâce à deux résistances différentes R et R'. On peut alors prévoir d'utiliser deux transistors montés chacun aux bornes de l'une des résistances R, R'. La configuration selon un premier mode de sélection consisterait à faire passer dans l'état ouvert le transistor aux bornes de la résistance R, alors que la configuration selon un deuxième mode de sélection consisterait à faire passer dans l'état ouvert le transistor aux bornes de la résistance R'. La configuration selon le mode par défaut consisterait à nouveau à faire repasser dans l'état fermé le transistor qui était dans l'état ouvert.

Il serait aussi possible que le composant de commutation ne soit pas utilisé en étant monté aux bornes d'un composant, mais soit utilisé pour réaliser la connexion ou déconnexion sélectives d'un composant au reste de l'étage de filtrage.

Le schéma électrique du dispositif de réception pourrait donc sûr être différent de celui présenté en figure 1.

On pourrait par exemple fusionner le circuit de filtrage additionnel et le filtre de base dans le but de réduire la surface d'implantation sur la carte électrique ainsi que le nombre et le coût des composants : des composants du circuit de filtrage additionnel seraient alors intégrés dans le filtre de base.

On pourrait également positionner le filtre RC passe-bas après l'amplificateur opérationnel (c'est-à-dire entre l'amplificateur opérationnel et le circuit de traitement), de manière à assurer une indépendance totale entre le circuit de filtrage additionnel et le filtre de base.

Bien que l'on ait décrit ici que le dispositif de réception est intégré dans un compteur électrique, il pourrait être intégré dans tout équipement électrique susceptible de recevoir des signaux CPL.

## Revendications

1. Dispositif de réception de signaux CPL, comprenant :

    - un étage de filtrage (3) relié à une entrée (E) du dispositif de réception et configurable selon au moins deux modes comprenant un mode par défaut, dans lequel l'étage de filtrage (3) laisse passer au moins des premiers signaux CPL inclus dans une première bande de fréquences et des deuxièmes signaux CPL inclus dans une deuxième bande de fréquences distincte de la première bande de fréquence, et un premier mode de sélection, dans lequel l'étage de filtrage laisse passer les premiers signaux CPL et empêche le passage des deuxièmes signaux CPL ;

    - un circuit de traitement (4) relié à l'étage de filtrage (3) et agencé pour recevoir des trames de signaux CPL, et, pour chaque trame reçue, pour analyser un préambule de la trame de manière à déterminer si la trame est une trame de premiers signaux CPL ou de deuxièmes signaux CPL, et pour configurer dynamiquement l'étage de filtrage (3) dans le premier mode de sélection si la trame est une trame de premiers signaux CPL de manière à optimiser la réception et le décodage de ladite trame.

2. Dispositif de réception selon la revendication 1, dans lequel le circuit de traitement (4) est agencé pour configurer l'étage de filtrage (3) dans le mode par défaut avant la réception de chaque nouvelle trame.

3. Dispositif de réception selon l'une des revendications précédentes, dans lequel l'étage de filtrage (3) comprend un composant de commutation (10) utilisé pour configurer l'étage de filtrage et agencé de sorte que, lorsque le composant de commutation se trouve dans un premier état, l'étage de filtrage se trouve dans le mode par défaut, et lorsque le composant de commutation se trouve dans un deuxième état, l'étage de filtrage se trouve dans le premier mode de sélection.

4. Dispositif de réception selon la revendication 3, dans lequel l'étage de filtrage comporte un filtre de base (6) et un circuit de filtrage additionnel (7), et dans lequel le composant de commutation est un transistor monté entre les bornes d'un composant (R) du circuit de filtrage additionnel.

5. Dispositif de réception selon la revendication 4, dans lequel le circuit de filtrage additionnel comporte en outre un amplificateur opérationnel (11) monté en suiveur, le circuit de filtrage additionnel (7) étant agencé de sorte que, lorsque le transistor est dans un état ouvert, le circuit de filtrage additionnel remplit une fonction de filtre, et lorsque le transistor est dans un état fermé, le circuit de filtrage additionnel remplit uniquement une fonction de suiveur.

6. Dispositif de réception selon la revendication 5, dans lequel le circuit de filtrage additionnel (7) comprend un filtre RC passe-bas comprenant une résistance (R) entre les bornes de laquelle est monté le transistor (10), ou bien un filtre RC passe-haut comprenant un condensateur entre les bornes duquel est monté le transistor.

7. Dispositif de réception selon la revendication 4, dans lequel le circuit de filtrage additionnel (7) est monté en sortie du filtre de base (6).

8. Dispositif de réception selon la revendication 4, dans lequel des composants du circuit de filtrage additionnel (7) sont intégrés dans le filtre de base (6).

9. Dispositif de réception selon l'une des revendications précédentes, dans lequel l'étage de filtrage est en outre configurable selon un deuxième mode de sélection, dans lequel l'étage de filtrage laisse passer les deuxièmes signaux CPL et empêche le passage des premiers signaux CPL.

10. Dispositif de réception selon la revendication 1, dans lequel, pour analyser le préambule de la trame, le circuit de traitement (4) est agencé pour appliquer une transformée de Fourier inverse sur des échantillons du préambule ou bien pour calculer une intercorrélation entre les échantillons et un signal de référence.

11. Equipement électrique comprenant un dispositif de réception selon l'une des revendications précédentes.

12. Equipement électrique selon la revendication 11, l'équipement électrique étant un compteur électrique.

13. Procédé de réception de signaux CPL, mis en œuvre dans un dispositif de réception de signaux CPL comprenant un étage de filtrage (3) et un circuit de traitement (4), l'étage de filtrage étant relié à une entrée (E) du dispositif de réception et le circuit de traitement étant relié à l'étage de filtrage et étant agencé pour recevoir des trames de signaux CPL, le procédé de réception comprenant les étapes de :

- utiliser l'étage de filtrage pour, lorsque l'étage de filtrage est configuré selon un mode par défaut, laisser passer au moins des premiers signaux CPL inclus dans une première bande de fréquences et des deuxièmes signaux CPL inclus dans une deuxième bande de fréquences distincte de la première bande de fréquence, et, lorsque l'étage de filtrage est configuré selon un premier mode de sélection, laisser passer les premiers signaux CPL et empêcher le passage des deuxièmes signaux CPL ;
le procédé de réception comprenant en outre les étapes, pour chaque trame reçue, de :

- acquérir et analyser, en utilisant le circuit de traitement du dispositif de réception, un préambule de la trame, de manière à déterminer si la trame est une trame de premiers signaux CPL ou de deuxièmes signaux CPL ;
- configurer dynamiquement, en utilisant le circuit de traitement, l'étage de filtrage (3) dans le premier mode de sélection si la trame est une trame de premiers signaux CPL de manière à optimiser la réception et le décodage de ladite trame.

14. Procédé de réception selon la revendication 13, comprenant en outre l'étape, avant la réception de la trame reçue, de configurer l'étage de filtrage (3) du dispositif de réception dans le mode par défaut.

15. Programme d'ordinateur comprenant des instructions de code de programme pour l'exécution des étapes du procédé de réception selon l'une des revendications 13 ou 14 lorsque ledit programme est exécuté sur ordinateur.

16. Moyens de stockage, **caractérisés en ce qu'**ils stockent un programme d'ordinateur comprenant des instructions pour mettre en œuvre, par un composant de traitement d'un modem, le procédé de réception selon l'une des revendications 13 ou 14.

**Patentansprüche**

1. Empfangsvorrichtung zum Empfangen von PLC-Signalen, umfassend:

- eine Filterstufe (3), die mit einem Eingang (E) der Empfangsvorrichtung verbunden und in mindestens zwei Modi konfigurierbar ist, einschließlich eines Standardmodus, in dem die Filterstufe (3) mindestens erste PLC-Signale, die in einem ersten Frequenzband enthalten sind, und zweite PLC-Signale, die in einem zweiten Frequenzband enthalten sind, das sich von dem ersten Frequenzband unterscheidet, durchlässt, und eines ersten Auswahlmodus, in dem die Filterstufe die ersten PLC-Signale durchlässt und den Durchlass der zweiten PLC-Signale verhindert;
- eine Verarbeitungsschaltung (4), die mit der Filterstufe (3) verbunden und ausgebildet ist, um Rahmen von PLC-Signalen zu empfangen und für jeden empfangenen Rahmen eine Präambel des Rahmens zu analysieren, um so zu bestimmen, ob der Rahmen ein Rahmen von ersten PLC-Signalen oder von zweiten PLC-Signalen ist, und um die Filterstufe (3) im ersten Auswahlmodus dynamisch zu konfigurieren, wenn der Rahmen ein Rahmen von ersten PLC-Signalen ist, um so den Empfang und die Dekodierung des genannten Rahmens zu optimieren.

2. Empfangsvorrichtung nach Anspruch 1, bei der die Verarbeitungsschaltung (4) ausgebildet ist, um die Filterstufe (3) vor dem Empfang jedes neuen Rahmens im Standardmodus zu konfigurieren.

3. Empfangsvorrichtung nach einem der vorhergehenden Ansprüche, bei der die Filterstufe (3) eine Schaltkomponente (10) umfasst, die verwendet wird, um die Filterstufe zu konfigurieren, und die derart ausgebildet ist, dass, wenn sich die Schaltkomponente in einem ersten Zustand befindet, sich die Filterstufe im Standardmodus befindet, und wenn sich die Schaltkomponente in einem zweiten Zustand befindet, sich die Filterstufe im ersten Auswahlmodus befindet.

4. Empfangsvorrichtung nach Anspruch 3, bei der die Filterstufe ein Basisfilter (6) und eine zusätzliche Filterschaltung (7) umfasst, und bei der die Schaltkomponente ein Transistor ist, der zwischen den Klemmen einer Komponente (R) der zusätzlichen Filterschaltung geschaltet ist.

5. Empfangsvorrichtung nach Anspruch 4, bei der die zusätzliche Filterschaltung ferner einen Operationsverstärker (11) umfasst, der als Folger geschaltet ist, wobei die zusätzliche Filterschaltung (7) derart ausgebildet ist, dass, wenn der Transistor in einem offenen Zustand ist, die zusätzliche Filterschaltung eine Filterfunktion erfüllt, und wenn der Transistor in einem geschlossenen Zustand ist, die zusätzliche Filterschaltung nur eine Folgerfunktion erfüllt.

6. Empfangsvorrichtung nach Anspruch 5, bei der die zusätzliche Filterschaltung (7) ein RC-Tiefpassfilter umfasst, das einen Widerstand (R) umfasst, zwischen dessen Klemmen der Transistor (10) geschaltet ist, oder auch ein RC-Hochpassfilter, das einen Kondensator umfasst, zwischen dessen Klemmen der Transistor geschaltet ist.

7. Empfangsvorrichtung nach Anspruch 4, bei der die zusätzliche Filterschaltung (7) am Ausgang des Basisfilters (6) geschaltet ist.

8. Empfangsvorrichtung nach Anspruch 4, bei der die Komponenten der zusätzliche Filterschaltung (7) in das Basisfilter (76) integriert sind.

9. Empfangsvorrichtung nach einem der vorhergehenden Ansprüche, bei der die Filterstufe ferner in einem zweiten Auswahlmodus konfigurierbar ist, in dem die Filterstufe die zweiten PLC-Signale durchlässt und den Durchlass der ersten PLC-Signale verhindert.

10. Empfangsvorrichtung nach Anspruch 1, bei der die Verarbeitungsschaltung (4) zur Analyse der Präambel des Rahmens so ausgebildet ist, dass sie eine umgekehrte Fourier-Transformation an Proben der Präambel anwendet oder eine Interkorrelation zwischen den Proben und einem Referenz-Signal berechnet.

11. Elektrische Ausrüstung, umfassend eine Empfangsvorrichtung nach einem der vorhergehenden Ansprüche.

12. Elektrische Ausrüstung nach Anspruch 11, wobei die elektrische Ausrüstung ein elektrischer Zähler ist.

13. Empfangsverfahren zum Empfangen von PLC-Signalen, das in einer Empfangsvorrichtung zum Empfangen von PLC-Signalen eingesetzt wird, die eine Filterstufe (3) und eine Verarbeitungsschaltung (4) umfasst, wobei die Filterstufe mit einem Eingang (E) der Empfangsvorrichtung verbunden ist und die Verarbeitungsschaltung mit der Filterstufe verbunden und ausgebildet ist, um Rahmen von PLC-Signalen zu empfangen, wobei das Empfangsverfahren die Schritte umfasst:

- Verwenden der Filterstufe, um, wenn die Filterstufe in einem Standardmodus konfiguriert ist, mindestens erste PLC-Signale, die in einem ersten Frequenzband enthalten sind, und zweite PLC-Signale, die in einem zweiten Frequenzband enthalten sind, das sich von dem ersten Frequenzband unterscheidet, durchzulassen, und, wenn die Filterstufe in einem ersten Auswahlmodus konfiguriert ist, um die ersten PLC-Signale durchzulassen und den Durchlass der zweiten PLC-Signale zu verhindern;
wobei das Empfangsverfahren ferner für jeden empfangenen Rahmen die Schritte umfasst:

- Erfassen und Analysieren einer Präambel des Rahmens, indem die Verarbeitungsschaltung der Empfangsvorrichtung verwendet wird, um zu bestimmen, ob der Rahmen ein Rahmen von ersten PLC-Signalen oder zweiten PLC-Signalen ist;
- dynamisches Konfigurieren der Filterstufe (3) in dem ersten Auswahlmodus, wenn der Rahmen ein Rahmen von ersten PLC-Signalen ist, indem die Verarbeitungsschaltung verwendet wird, um so den Empfang und die Dekodierung des genannten Rahmens zu optimieren.

14. Empfangsverfahren nach Anspruch 13, ferner umfassend vor dem Empfang des empfangenen Rahmens den Schritt des Konfigurierens der Filterstufe (3) der Empfangsvorrichtung im Standardmodus.

**15.** Computerprogramm, umfassend Programmcode-Anweisungen zur Ausführung der Schritte des Empfangsverfahrens nach einem der Ansprüche 13 oder 14, wenn das genannte Programm auf dem Computer ausgeführt wird.

**16.** Speichermittel, **dadurch gekennzeichnet, dass** sie ein Computerprogramm speichern, das Anweisungen zum Durchführen des Empfangsverfahrens nach einem der Ansprüche 13 oder 14 durch eine Verarbeitungskomponente eines Modems umfasst.

**Claims**

**1.** Device for receiving PLC signals, comprising:

- a filtering stage (3) linked to an input (E) of the receiving device and configurable in at least two modes comprising a default mode, wherein the filtering stage (3) passes at least first PLC signals included in a first frequency band and second PLC signals included in a second frequency band separate from the first frequency band, and a first selection mode, in which the filtering stage passes the first PLC signals and stops the second PLC signals;

- a processing circuit (4) linked to the filtering stage (3) and arranged to receive frames of PLC signals, and, for each received frame, to analyse a preamble of the frame in order to determine if the frame is a frame of first PLC signals or of second PLC signals, and to dynamically configure the filtering stage (3) in the first selection mode if the frame is a frame of first PLC signals such as the optimize the receipt and the decoding of said frame.

**2.** Receiving device according to Claim 1, wherein the processing circuit (4) is arranged to configure the filtering stage (3) in the default mode before the receipt of each new frame.

**3.** Receiving device according to one of the preceding claims, wherein the filtering stage (3) comprises a switching component (10) used to configure the filtering stage and arranged such that, when the switching component is in a first state, the filtering stage is in the default mode, and when the switching component is in a second state, the filtering stage is in the first selection mode.

**4.** Receiving device according to Claim 3, wherein the filtering stage includes a base filter (6) and an additional filtering circuit (7), and wherein the switching component is a transistor mounted between the terminals of a component (R) of the additional filtering circuit.

**5.** Receiving device according to Claim 4, wherein the additional filtering circuit further includes an operational amplifier (11) connected as a follower, the additional filtering circuit (7) being arranged such that, when the transistor is in an open state, the additional filtering circuit fulfils a filter function, and when the transistor is in a closed state, the additional filtering circuit only fulfils a follower function.

**6.** Receiving device according to Claim 5, wherein the additional filtering circuit (7) comprises a low-pass RC filter comprising a resistor (R) between the terminals of which the transistor (10) is mounted, or a high-pass RC filter comprising a capacitor between the terminals of which the transistor is mounted.

**7.** Receiving device according to Claim 4, wherein the additional filtering circuit (7) is mounted at the output of the base filter (6).

**8.** Receiving device according to Claim 4, wherein components of the additional filtering circuit (7) are integrated into the base filter (6).

**9.** Receiving device according to one of the preceding claims, wherein the filtering stage is furthermore configurable in a second selection mode, wherein the filtering stage passes the second PLC signals and stops the first PLC signals.

**10.** Receiving device according to Claim 1, wherein, in order to analyse the preamble of the frame, the processing circuit (4) is arranged to apply an inverse Fourier transform to samples of the preamble or to calculate a cross-correlation between the samples and a reference signal.

**11.** Electrical equipment comprising a receiving device according to one of the preceding claims.

**12.** Electrical equipment according to Claim 11, the electrical equipment being an electric meter.

**13.** Method for receiving PLC signals, implemented in a receiving device of PLC signal comprising a filtering stage (3) and a processing circuit (4), the filtering stage being linked to an input (E) of the receiving device and the processing circuit being linked to the filtering stage and being arranged to receive frames of PLC signal, the method comprising the steps of:

- using the filtering stage for, when the filtering stage is configured in a default mode, pass at least first PLC signals included in a first frequency band and second PLC signals included in a second frequency band separate from the first frequency band and, when the filtering stage is configured in a first selection mode, pass the first PLC signals and stop the second PLC signals,

the method further comprising the steps, for each received frame, to:

- acquiring and analysing, by using the processing circuit of the receiving device, a preamble of the frame, such as to determine if the frame is a frame of first PLC signals or of second PLC signals;
- dynamically configuring, by using the processing circuit, the filtering stage (3) in the first selection mode if the frame is a frame of first PLC signals in such a way to optimize reception and decoding of said frame.

14. Receiving method according to Claim 13, further comprising the step, before the reception of the frame, to configure the filtering stage (3) of the receiving device in the default mode.

15. Computer program comprising program code instructions for the execution of the steps of the receiving method according to one of Claims 13 or 14 when said program is executed on a computer.

16. Storage means, **characterized in that** they store a computer program comprising instructions for implementing, via a processing component of a modem, the receiving method according to one of Claims 13 or 14.

**Fig. 1**

Fig. 2a

Fig. 2b

Fig. 2c

| Sp | Sp | Sp | Sp | Sp | Sp | Sp | Sp | Sm | Sm/2 |
|----|----|----|----|----|----|----|----|----|------|
| S Y N C P | S Y N C P | S Y N C P | S Y N C P | S Y N C P | S Y N C P | S Y N C P | S Y N C P | S Y N C M | S Y N C M |

...

**Fig. 3**

SYNCP
(CENELEC A)

P0 ... P35

**Fig. 4**

SYNCP
(FCC)

P0 ... P71

**Fig. 5**

## RÉFÉRENCES CITÉES DANS LA DESCRIPTION

**Documents brevets cités dans la description**

- WO 2016166238 A1
- EP 3104569 A1